# EUROPEAN PATENT APPLICATION

(11) **EP 4 425 778 A1**
(43) Date of publication of application: **04.09.2024**
(21) Application number: 21962093.7
(22) Date of filing: 11.11.2021
(51) Int. Cl.: H02M 3/156, H02M 1/088, H03K 17/042

(54) **CIRCUIT FOR IMPROVING LOAD SWITCHING RESPONSE SPEED AND METHOD THEREFOR**

(30) Priority: 27.10.2021 CN 202111260777
(71) Applicant: Shaanxi Reactor Microelectronics Co., Ltd., Xi'an, Shaanxi 710075 (CN)
(72) Inventor: HE, Shibao, Xi'an, Shaanxi 710075 (CN); WANG, Jiawei, Xi'an, Shaanxi 710075 (CN); XIA, Qin, Xi'an, Shaanxi 710075 (CN)
(74) Representative: Zaboliene, Reda
(86) International application number: PCT/CN2021/129940
(87) International publication number: WO 2023/070747

(57) **Abstract**

The present invention discloses a circuit and a method for improving the response speed of load switching, a switch unit comprising a switch circuit and a switch unit control part; the switch circuit comprises a first power tube and a second power tube connected in series; a switch filter unit, comprising a working status judgment module, a first switch, a second switch, a third switch, a first inductor and a second inductor; the working status judgment module is used to determine whether the system is in startup, or normal operation, or load switching status, and make the system turn on or close said first switch, second switch, and third switch in different situations, so as to obtain a suitable inductor operation according to the different inductances of first inductor and second inductor and improve system response speed. The invention can improve the response speed of the system and make the ripple smaller.

## Description

### Technical Field

The present invention relates to the technical field of envelope tracking (ET) power supplies, in particular, to a circuit for improving the response speed of load switching.

### Background Art

Envelope tracking (ET) power supply is to extract the envelope of the input signal of the power amplifier (PA), use a certain circuit structure, and track the envelope of the input signal by adjusting the power supply voltage of the PA dynamically, so that the power supply voltage of the power amplifier dynamically follows the envelope of the input signal, completes the modulation of the drain voltage of the power amplifier, and thus achieves efficiency improvement. When the load current of an electronic circuit undergoes a transient, the output voltage generally needs to be maintained within a specific tolerance range to ensure the normal operation of the circuit. The inductor in the traditional switch unit or envelope tracking power supply generates a voltage in response to the changing current when the load is switched: V = Ldi/dt.

The existing switch unit or envelope tracking power supply has only one inductor, and an inductor with a larger inductance is usually selected in order to ensure the system ripple and make the peak-to-peak value of the inductor current smaller. However, the large inductance will make the load switching response slower.

The above-mentioned information disclosed in the background art is only for enhancing the understanding of the background of the present invention, and therefore may contain information that does not constitute prior art known to those of ordinary skill in the art.

### Summary of the Invention

The purpose of the present invention is to provide a circuit that improves the response speed of load switching and improves the response speed.

In order to achieve the above objectives, the present invention provides the following technical solutions:
A circuit for improving the response speed of load switching of the present invention comprises:
A switch unit, which comprises a switch circuit and a switch unit control part, the switch circuit comprises a first power tube and a second power tube connected in series;
A switch filter unit, which comprises a working status judgment module, a first switch, a second switch, a third switch, a first inductor and a second inductor;
Said working status judgment module is used to determine whether the system is in startup, or normal operation, or load switching status, and make the system turn on or close said first switch, second switch, and third switch in different situations, so as to obtain a suitable inductor operation according to the different inductances of first inductor and second inductor.

In said circuit for improving the response speed of load switching, the working status judgment module comprises:
A first comparator, of which the positive input terminal inputs a first preset current value and the negative input terminal inputs a current value Iout,
A second comparator, of which the negative input terminal inputs a second preset current value, the positive input terminal inputs a current value Iout, the negative input terminal of the first comparator and the positive input terminal of the second comparator are connected,
A second inverter, the output terminal of the first comparator is connected with the second inverter, the output terminal of the second inverter is connected with the input terminal of a first AND gate, and the other input terminal of the first AND gate is connected with a first level S1, and the first AND gate outputs a third level S3;
The input terminal of a first NAND gate is connected to the output terminals of the second comparator and the first comparator respectively; the output terminal of the first NAND gate is connected to the input terminal of a second AND gate, the other input terminal of the second AND gate is connected to ss_ok signal, the output terminal of the second AND gate is connected to the first inverter, the second AND gate outputs the first level S1, and the output signal of the first inverter is a second level S2.

In said circuit for improving the response speed of load switching, when the soft-start signal ends or the load output voltage Vout has been built up, the ss_ok signal is high level H; when the soft-start occurs or the load output voltage Vout has not been built up, the ss_ok signal is low level L.

In said circuit for improving the response speed of load switching, the first preset current value I1 is 1.25 times the average value of the load current, and the second preset current value I2 is 0.75 times the average value of the load current, wherein said specific multiple is adjusted according to the load switching state. Principle of adjustment: If the set multiple is too small, the sensitivity of the working status judgment module is too high, which may cause the normal working status to be mistakenly judged as the load switching status when judging the system status; if the set multiple is too large, the sensitivity of the working status judgment module is too low, which may cause two kinds of switching with similar load size (1:1~1.3) can't be judged as load switching.

A method based on said circuit for improving the response speed of load switching, characterized in that, it comprises the following steps:
The working status judgment module outputs the first level S 1, the second level S2, and the third level S3 when it determines that the system is in startup and normal operation status, at this moment, the first level S1 is low, the second level S2 is high, the third level S3 is low, the first switch K1 is turned off, the second switch K2 is turned on, and the third switch K3 is turned off;
When the working status judgment module determines that it is in load switching status, the first level S1 is high, the second level S2 is low, the first switch K1 is turned on, and the second switch K2 is turned off. There are two modes of load switching: when the light load is switched to heavy load, the third level S3 is high and K3 is on; when the heavy load is switched to light load, the third level S3 is low and K3 is off.

In the above technical solution, the circuit and method for improving the response speed of load switching provided by the present invention have the following beneficial effects: the present invention adopts large and small dual inductors, and the working status judgment module is used to: Connect the large inductor and the small inductor in series during normal operation; select the small inductor during load switching so that the small inductor is connected to the system alone. This not only ensures that the system ripple value is controlled at a certain level, but also improves the response speed of load switching.

### Description of the Drawings

In order to explain the embodiments of the present application or the technical solutions in the prior art more clearly, the drawings that need to be used in the embodiments are briefly introduced below, it is clear that the drawings in the following description are only some of the embodiments described in the present invention, for those of ordinary skill in the art, other drawings may be obtained based on these drawings.
Figure 1 is a structure diagram of an envelope tracking power supply according to an embodiment of the present invention;
Figure 2 is a structure diagram of a circuit for improving the response speed of load switching according to an embodiment of the present invention;
Figure 3 is a structure diagram of a working status judgment module according to an embodiment of the present invention;
Figure 4 is a structure diagram of a circuit for improving the response speed of load switching according to an embodiment of the present invention;
Figure 5 is a waveform diagram when switching with a small inductive load in the prior art;
Figure 6 is a waveform diagram when switching with a large inductive load in the prior art;
Figure 7 is a waveform diagram when switching with large and small inductive loads in an embodiment of the present invention.

### Mode of Carrying out the Invention

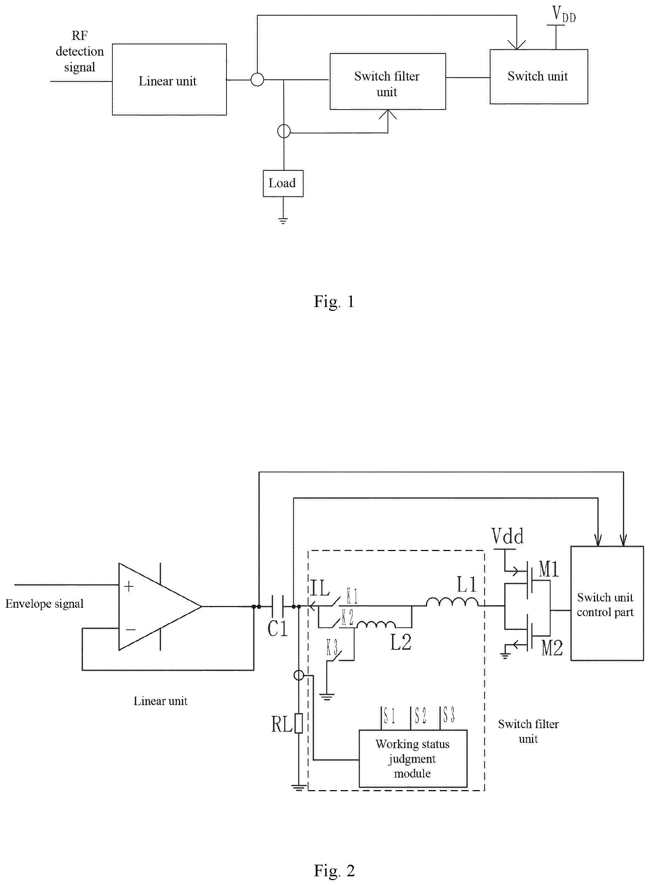

In order to make the objectives, technical solutions, and advantages of the embodiments of the present invention clearer, the technical solutions in the embodiments of the present invention will be described clearly and completely with reference to Figures 1 to 7 in the embodiments of the present invention; it is clear that the described embodiments are part of the embodiments of the present invention, rather than all of the embodiments. Based on the embodiments of the present invention, all other embodiments obtained by those of ordinary skill in the art without creative work shall fall within the protection scope of the present invention.

Therefore, the following detailed description of the embodiments of the present invention provided in the accompanying drawings is not intended to limit the scope of the claimed invention, but merely represents selected embodiments of the present invention. Based on the embodiments of the present invention, all other embodiments obtained by those of ordinary skill in the art without creative work shall fall within the protection scope of the present invention.

It should be noted that similar reference signs and letters indicate similar items in the following drawings; therefore, once an item is defined in one drawing, it does not need to be further defined and explained in the subsequent drawings.

In the description of the present invention, it should be understood that the orientation or location relationship indicated by terms "center", "longitudinal", "transverse", "length", "width", "thickness", "upper", "lower", "front", "back", "left", "right", "vertical", "horizontal", "top", "bottom", "inner", "outer", "clockwise", and "counterclockwise" is based on the orientation or location relationship shown in the drawings, which is only for the convenience of describing the present invention and simplifying the description, and does not indicate or imply that the indicated device or element must have a specific orientation, be constructed and operated in a specific orientation, therefore, it can't be understood as a limitation to the present invention.

In addition, the terms "first" and "second" are only used for descriptive purposes, and can't be understood as indicating or implying relative importance or implicitly indicating the number of indicated technical features. Therefore, the features defined with "first" and "second" may explicitly or implicitly include one or several of these features. In the description of the present invention, "multiple" means two or more than two, unless specifically defined otherwise.

In the present invention, unless otherwise clearly specified and limited, "install", "connected", "connection", "fix" and other terms should be understood in a broad sense, for example, it can be a fixed connection or a detachable connection, or integrated; it can be directly connected, or indirectly connected through an intermediate medium, it can be the internal connection of two elements or the interaction relationship between two elements. For those of ordinary skill in the art, the specific meanings of the above-mentioned terms in the present invention can be understood according to specific circumstances.

In the present invention, unless expressly stipulated and defined otherwise, the first feature "above" or "below" the second feature may include direct contact between the first and second features, or may include the first and second features not in direct contact but contact through other features between them. Moreover, the first feature "above", "over" and "on top of" the second feature includes the first feature being directly above and obliquely above the second feature, or merely indicates that the level of the first feature is higher than that of the second feature. The first feature "below", "under" and "beneath" the second feature includes the first feature directly below and obliquely below the second feature, or merely indicates that the level of the first feature is lower than the second feature.

In order to enable those skilled in the art to better understand the technical solutions, the present invention will be further described in detail below with reference to the accompanying drawings.

In an embodiment, the present invention discloses a circuit for improving the response speed of load switching, comprising:
A switch unit, which comprises a switch circuit and a switch unit control part, the switch circuit comprises a first power tube and a second power tube connected in series;
A switch filter unit, which comprises: a working status judgment module, a first switch, a second switch, a third switch, a first inductor and a second inductor;
Said working status judgment module is used to determine whether the system is in startup, or normal operation, or load switching status, and make the system turn on or close said first switch, second switch, and third switch in different situations, so as to obtain a suitable inductor operation according to the different inductances of first inductor and second inductor.

That is to say, the key idea of the present invention is the different inductors and working status judgment module, which are used to determine whether the system is in startup, or normal operation, or load switching status, and make the system obtain proper inductor operation according to the first inductor and the second inductor in different states. This can improve the response speed of the system. Moreover, this can also control the system ripple to a certain level, thereby making the ripple smaller.

As shown in Figure 1, a circuit for improving the response speed of load switching, comprising a linear unit, a switch filter unit, and a switch unit, said linear unit inputs a radio frequency detection signal, said linear unit is coupled to the switch filter unit, and one end of said switch filter unit is connected to the switch unit; a load is coupled and connected between said switch filter unit and the linear unit;

Said linear unit is used to amplify the power of a set multiple of the radio frequency detection signal to provide an AC voltage to the load; in addition, said linear unit also has the function of filtering noise; said linear unit has both signal amplification and noise filtering.

Said radio frequency detection signal may be an envelope signal;

Said switch unit is used to generate a square wave with a certain duty cycle according to the voltage provided by the linear unit to the load and the output voltage on the load;

Said switch filter unit is used to filter said square wave into a DC voltage and a DC current, and select different filter units according to the working state of the system, wherein,

Different filter units have different inductances.

It can be understood that this embodiment implements different inductances through different filter units, and implements the function of the working status judgment module through switch filter units.

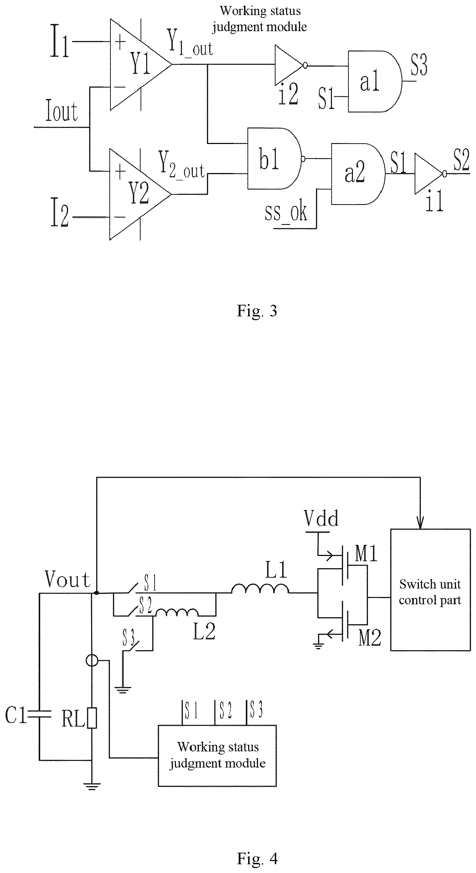

In an embodiment, as shown in Figures 2 and 3, a circuit for improving the response speed of load switching comprises: said switch filter unit comprises: a working status judgment module, a first switch K1, a second switch K2, and a third switch K3, a first inductor L1 and a second inductor L2, one end of said working status judgment module is connected to the load, said K1 is connected to L1, said K2 is connected to L2, said K2 and L2 are connected in parallel to K3, one end of K3 is grounded, one end of said L1 is connected to the switch unit, and one end of said K1 and K2 are connected in parallel with the load;

A switch unit, which comprises a switch circuit and a switch unit control part, the switch circuit comprises a first power tube M1 and a second power tube M2 connected in series;

Wherein, L1 is a small inductor, and L2 is a large inductor, especially, when 10*L1≤L2, the effect of improving the load switching response speed is obvious.

The working status judgment module is connected to said switches K1, K2, K3 respectively, and the working status judgment module outputs the first level S1, the second level S2 and the third level S3 when the system is in startup and normal operation state, the first level S1 is low, the second level S2 is high, the third level S3 is low, K1 is off, K2 is on, and K3 is off; when the working status judgment module is switching the load, the first level S1 is high, the second level S2 is low, K1 is on, and K2 is off.

Wherein, the first level S1 controls the on/off of the first switch K1; the second level S2 controls the on/off of the second switch K2; the third level S3 controls the on/off of the third switch K3.

In the preferred embodiment of the circuit for improving the response speed of load switching, as shown in Figure 3, the working status judgment module comprises,

A first comparator, of which the positive input terminal inputs a first preset current value and the negative input terminal inputs a current value Iout,

A second comparator, of which the negative input terminal inputs a second preset current value, the positive input terminal inputs a current value Iout, the negative input terminal of the first comparator and the positive input terminal of the second comparator are connected,

A second inverter, the output terminal of the first comparator is connected with the second inverter, the output terminal of the second inverter is connected with the input terminal of a first AND gate, and the other input terminal of the first AND gate is connected with a first level S1, and the first AND gate outputs a third level S3;

The input terminal of a first NAND gate is connected to the output terminals of the second comparator and the first comparator respectively; the output terminal of the first NAND gate is connected to the input terminal of a second AND gate, the other input terminal of the second AND gate is connected to ss_ok signal, the output terminal of the second AND gate is connected to the first inverter, the second AND gate outputs the first level S1, and the output signal of the first inverter is a second level S2.

In the preferred embodiment of the circuit for improving the response speed of load switching, when the light load is switched to the heavy load, the third level S3 is high and K3 is turned on; when the heavy load is switched to the light load, the third level S3 is low, and K3 is turned off.

For this embodiment, the third level S3, which can respond to changes in light and heavy loads, also has a special effect: when the load is switched from light to heavy, L2 is grounded to give an initial current while switching to small inductor L1; if there is no third level S3, when the light load is switched to heavy load, S1=H, S2=L, the state switches to S1=L, S2=H, IL will change to 0 as the L2 current will not change suddenly.

In an embodiment, the present invention also discloses a method based on the circuit for improving the response speed of load switching, which is characterized in that it comprises the following steps:
The working status judgment module outputs the first level S1, the second level S2, and the third level S3 when it determines that the system is in startup and normal operation status, at this moment, the first level S1 is low, the second level S2 is high, the third level S3 is low, the first switch K1 is turned off, the second switch K2 is turned on, and the third switch K3 is turned off;
When the working status judgment module determines that it is in load switching status, the first level S1 is high, the second level S2 is low, the first switch K1 is turned on, the second switch K2 is turned off, and the third switch K3 is turned on. Furthermore, there are two modes of load switching: when the light load is switched to heavy load, the third level S3 is high and K3 is on; when the heavy load is switched to light load, the third level S3 is low and K3 is off.
In the method for improving the response speed of load switching, when the soft start is over or the load output voltage Vout has been built up normally, ss_ok=H, that is, high level; when the soft start or the load output voltage Vout has not built up, ss_ok= L, that is, low level.

In other words, ss_ok is the build-up signal of soft start or load output voltage Vout.

In said method of improving the response speed of load switching, I1 is 1.25 times the average load current, and I2 is 0.75 times the average load current, the specific multiple can be adjusted according to the system; if the set multiple is too small, the sensitivity of the working status judgment module is too high, which may cause the normal working status to be mistakenly judged as the load switching status when judging the system status;

If the set multiple is too large, the sensitivity of the working status judgment module is too low, which may cause two kinds of switching with similar load size (1:1~1.3) can't be judged as load switching.

Wherein, I1 is more than 1 time the average value of the load current, and I2 is less than 1 time the average value of the load current.

At the moment of load switching, Iout must jump suddenly, but I1 and I2 will not respond immediately. When the load increases or decreases by more than 25%, the output of the comparators Y1 and Y2 must change by L;
1. When ss_ok=L, S1=L, S2=H, S3=L, inductors L1 and L2 are connected to the system in series to ensure that the peak-to-peak value of the inductor current is small during the startup phase of the system;
2. When ss_ok=H, I2≤Iout≤I1, Y1-out=H, Y2-out=H, S1=L, S2=H, S3=L, inductors L1 and L2 are connected to the system in series to ensure that the peak-to-peak value of the inductor current is small when the system is working normally;
3. When ss_ok=H, Iout>I1, Y1-out=L, S1=H, S2=L, S3=H; when Iout<12, Y2-out=L, S1=H, S2 =L, S3=L, it indicates that the load is switched, in order to increase the switching speed, connect the inductor L1 to the system and disconnect L2, when the switching is completed, I2≤Iout≤I1, the inductors L1 and L2 are connected to the system in series. The small inductor L1 ensures that the system has a sufficiently fast response speed at this moment. So far, the circuit realizes that the large inductor L2 and the small inductor L1 are connected in series during system startup and normal operation, which ensures that the system ripple value is small; when the load is switched, the small inductor L1 is selected to connect to the system separately, which improves the response speed of load switching.

The function of S3: When the load is switched from light to heavy, L2 is grounded to give an initial current while switching to small inductor L1; if there is no third level S3, when the light load is switched to heavy load, S1=H, S2=L, the state switches to S1=L, S2=H, IL will change to 0 as the L2 current will not change suddenly.

In an embodiment, as shown in Figure 2, it illustrates a circuit for improving the response speed of load switching, and the circuit can also realize the function of envelope tracking power supply. The present invention discloses a dynamic current supply circuit, which comprises a linear unit for inputting an envelope signal, the aforementioned switch filter unit and a switch unit.

Figure 4 is the application of the circuit for improving the response speed of load switching in a switching power supply according to the present invention;

Compared with the prior art, although the prior art has a scheme in which multiple inductors are connected to multiple switching circuits and control parts respectively, it is one-to-one control and is used to realize power supply to the RF power amplifier from a linear voltage source and N current sources together. However, in the present invention, two inductors of different sizes achieve proper inductive operation in different states, which is used to improve the response speed of the system and ensure that the ripple is small when the system is working normally. This is the essential feature of the present invention.

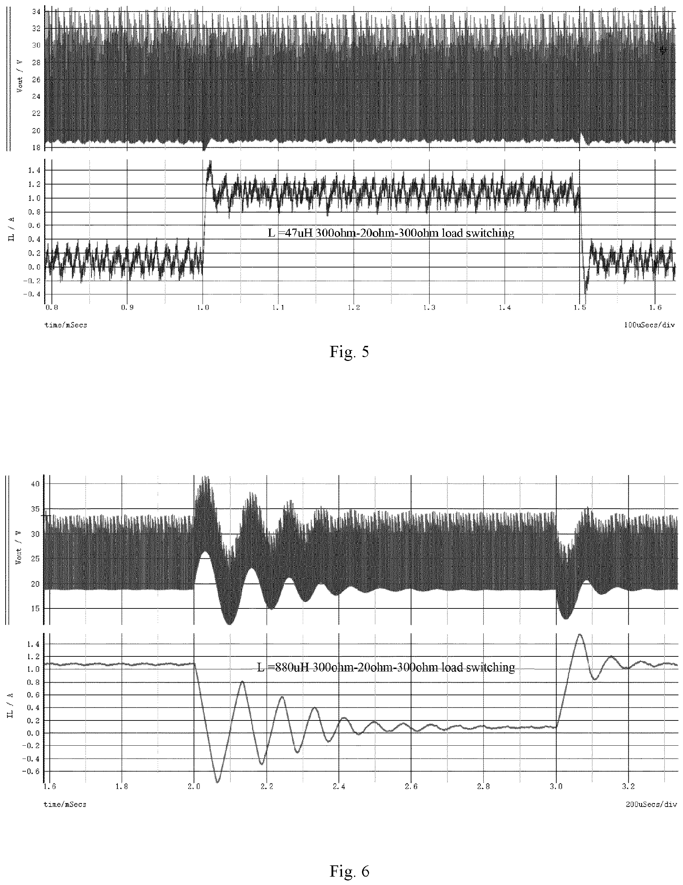

As shown in Figure 5, Figure 6 and Figure 7, the abscissa represents time, Vout on the ordinate represents the output voltage on the load, IL represents the inductor current; in Figure 5, one solution of the prior art is to select a small inductor, such as 47uH, when the load is switched from 300ohm~20ohm~300ohm, the speed is very fast, the output voltage overshoot and undershoot on the load are small, but the inductor current ripple is large in the steady state before and after load switching, and the output voltage ripple on the load is large.

In Figure 6, another solution in the prior art is to choose a large inductance for the inductor. For example, when the inductance is 880uH, the switching speed is very slow when the load is switched from 300ohm~20ohm~300ohm, the output voltage overshoot and undershoot on the load are large, and the oscillation is very serious, but the inductor current ripple is small in the steady state before and after load switching, and the output voltage ripple on the load is small.

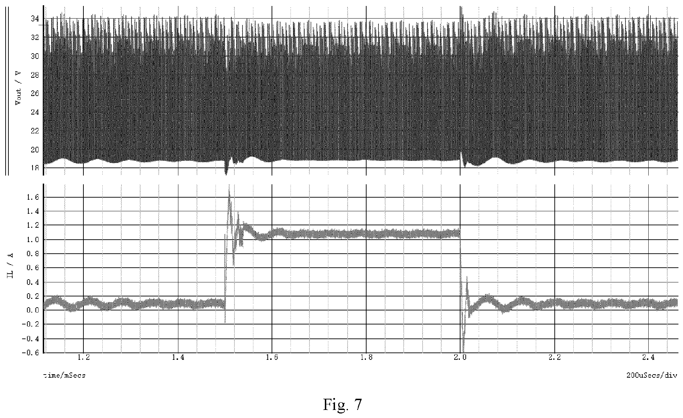

In another embodiment, it can also make the large and small inductors work together during normal operation. Refer to Figure 7, the abscissa represents time, Vout on the ordinate represents the output voltage on the load, IL represents the inductor current: use small inductor (47uH) when the load is switched, uses large inductor and small inductor (880uH+47uH) during normal operation, exemplarily, when the load is switched from 300ohm~20ohm~300ohm, the speed is very fast, the output voltage overshoot and undershoot on the load are very small, the inductor current ripple is small in the steady state before and after load switching, and the output voltage ripple on the load is small.

Through the comparison of Figure 5, Figure 6, and Figure 7, compared with the prior art, the present invention adopts large and small inductor in combination, so that the speed is very fast when the load is switched from 300ohm~20ohm~300ohm, the output voltage overshoot and undershoot on the load are very small, the inductor current ripple is small in the steady state before and after load switching, and the output voltage ripple on the load is small.

That is to say, in this embodiment, when the large and small inductor mode is adopted, the effectiveness of the large and small inductors is determined through the output levels S1, S2 and S3 of the working status judgment module: a large inductor and a small inductor are connected in series during system startup and normal operation; a small inductor is connected to the system alone when switching the load. This embodiment not only ensures that the system ripple value is small, but also improves the response speed of load switching.

Finally, it should be noted that the described embodiments are only a part of the embodiments of the present application, not all of the embodiments, and based on the embodiments of the present application, all other embodiments obtained by those skilled in the art without creative work shall fall within the protection scope of this application.

The above only describes some exemplary embodiments of the present invention by illustration, there is no doubt that for those of ordinary skill in the art, a variety of different ways can be used to modify the described embodiment without departing from the spirit and scope of the present invention. Therefore, the above drawings and descriptions are illustrative in nature and should not be construed as limiting the scope of protection of the claims of the present invention.

## Claims

1. A circuit for improving the response speed of load switching, **characterized in that**, it comprises:
A switch unit, which comprises a switch circuit and a switch unit control part, the switch circuit comprises a first power tube and a second power tube connected in series;
A switch filter unit, which comprises a working status judgment module, a first switch, a second switch, a third switch, a first inductor and a second inductor;
Said working status judgment module is used to determine whether the system is in startup, or normal operation, or load switching status, and make the system turn on or close said first switch, second switch, and third switch in different situations, so as to obtain a suitable inductor operation according to the different inductances of first inductor and second inductor.

2. The circuit for improving the response speed of load switching according to claim 1, **characterized in that**, the working status judgment module comprises:
A first comparator, of which the positive input terminal inputs a first preset current value and the negative input terminal inputs a current value Iout,
A second comparator, of which the negative input terminal inputs a second preset current value, the positive input terminal inputs a current value Iout, the negative input terminal of the first comparator and the positive input terminal of the second comparator are connected,
A second inverter, the output terminal of the first comparator is connected with the second inverter, the output terminal of the second inverter is connected with the input terminal of a first AND gate, and the other input terminal of the first AND gate is connected with a first level S1, and the first AND gate outputs a third level S3;
The input terminal of a first NAND gate is connected to the output terminals of the second comparator and the first comparator respectively; the output terminal of the first NAND gate is connected to the input terminal of a second AND gate, the other input terminal of the second AND gate is connected to ss_ok signal, the output terminal of the second AND gate is connected to the first inverter, the second AND gate outputs the first level S1, and the output signal of the first inverter is a second level S2.

3. The circuit for improving the response speed of load switching according to claim 2, **characterized in that**, when the soft-start signal ends or the load output voltage Vout has been built up, the ss_ok signal is high level H; when the soft-start occurs or the load output voltage Vout has not been built up, the ss_ok signal is low level L.

4. The circuit for improving the response speed of load switching according to claim 3, **characterized in that**, the first preset current value I1 is 1.25 times the average value of the load current, and the second preset current value I2 is 0.75 times the average value of the load current, wherein said specific multiple is adjusted according to the load switching state.

5. A circuit method for improving the response speed of load switching based on any one of claims 1-4, **characterized in that**, it comprises the following steps:
The working status judgment module outputs the first level S1, the second level S2, and the third level S3 when it determines that the system is in startup and normal operation status, at this moment, the first level S1 is low, the second level S2 is high, the third level S3 is low, the first switch K1 is turned off, the second switch K2 is turned on, and the third switch K3 is turned off;
When the working status judgment module determines that it is in load switching status, the first level S1 is high, the second level S2 is low, the first switch K1 is turned on, and the second switch K2 is turned off.
